# EUROPEAN PATENT APPLICATION

(11) **EP 4 697 530 A1**
(43) Date of publication of application: **18.02.2026**
(21) Application number: 25188982.0
(22) Date of filing: 11.07.2025
(51) Int. Cl.: H02H 9/04, H02H 3/08, H02H 3/33, H02H 3/347, H02H 7/00, G01R 31/12, H01T 1/14, H01H 3/00, H02H 3/093

(54) **PROTECTION APPARATUS FOR PROTECTING A SURGE PROTECTION DEVICE**

(30) Priority: 16.07.2024 CN 202410952390
(71) Applicant: CITEL, 75014 Paris (FR)
(72) Inventor: LI, Xiaozhen, 201315 SHANGHAI (CN); YE, Jianzhe, 201315 SHANGHAI (CN); WANG, Hui, 201315 SHANGHAI (CN); DENG, Xueping, 201315 SHANGHAI (CN); ZHU, Zewei, 201315 SHANGHAI (CN)
(74) Representative: Loyer & Abello

(57) **Abstract**

A protection apparatus (30) for protecting a surge protection device comprises:
a current-diverting circuit connectable between a surge protection device and a power distribution circuit, the current-diverting circuit comprising a main switch (3),
a current sensor (8) configured to generate a detection signal in response to detecting a current in the current-diverting circuit,
and a controller (9) configured to test a tripping condition and to open the main switch (3) in response thereto, wherein the tripping condition is configured to avoid opening the main switch in response to the surge current,
wherein the current-diverting circuit further comprises a fuse element (7) connected in series with the main switch, wherein the fuse element is rated to withstand the surge current and to melt into an open state in response to a high intensity current, in an urgent disconnection delay shorter than a time required by the controller to test the tripping condition.

## Description

### Field of the invention

The disclosure relates to the field of power distribution systems, in particular to protection apparatuses and systems.

### Background

At present, surge protective devices (SPD) are widely used in low-voltage power distribution systems in various scenarios to provide safety protection for various electronic equipment, to avoid surges caused by external interference, that is, instantaneous overvoltages that exceed normal conditions cause damage to equipment.

Due to Metal Oxide Varistors (MOV), there is a need to detect malfunction of the SPD and to provide protection functions, which are able to disconnect the SPD before the MOV explodes or catches fire.

For that purpose, it is known to supplement the SPD with a thermal disconnection device and to provide a backup protection device including a circuit breaker. However, it is known e.g. in EP-A-4138242, that the combined thermal disconnection device and circuit breaker fail to provide sufficient protection because of a middle current between the current threshold for triggering the SPD internal protection and the current threshold for triggering the circuit breaker.

### Summary of the Invention

Aspects of the disclosure aim at improving the protection of SPDs against risks such as electrical fire and the like.

According to an embodiment, there is provided a protection apparatus for protecting a surge protection device, the protection apparatus comprising:
a current-diverting circuit connectable between a surge protection device and a power distribution circuit, the current-diverting circuit comprising a main switch, the current-diverting circuit and the surge protection device being configured to divert a surge current from the power distribution circuit,
a current sensor configured to generate a detection signal in response to detecting a current in the current-diverting circuit,
and a controller configured to test a tripping condition and to open the main switch in response to detecting that the detection signal meets the tripping condition, wherein the tripping condition is configured to avoid opening the main switch in response to the surge current,
wherein the current-diverting circuit further comprises a fuse element connected in series with the main switch, wherein the fuse element is rated to withstand the surge current and
to melt into an open state within an urgent disconnection delay in response to a high intensity current, wherein the urgent disconnection delay is shorter than a time required by the controller to test the tripping condition.

Thanks to these features, it is possible to improve the protection of an SPD by combining a fuse element and a main switch, e.g. implemented as a residual current device. The fuse element is selected to ensure protection against a high intensity fault current, e.g. from few thousands of amperes to 100,000A or more. The main switch or residual current device may implemented to ensure protection against an intermediate fault current, e.g. around a few amperes to a few thousands of amperes. In addition, the SPD may have an internal thermal disconnection device for protection against a lower fault current, e.g. below a few amperes.

According to embodiments, such a protection apparatus may include one or more of the following features.

Obviously such a protection apparatus would completely inhibit the protection function of the surge protection device if the controller opened the main switch every time a surge current arises. Therefore, the tripping condition must involve some delay to avoid opening the main switch in response to the surge current. For that purpose the tripping condition may be expressed in different ways, e.g. in the time domain or in the frequency domain.

In an embodiment, expressed in the time domain, the tripping condition is a function of a time threshold, wherein testing the tripping condition comprises testing that the detection current remains above a positive detection threshold for a duration longer than the time threshold, the time threshold being longer than a typical duration of the surge current

In an embodiment, the controller is further configured to detect the open state of the fuse element and to open the main switch in response to detecting the open state of the fuse element.

Thanks to these features, the controller protects the melted fuse element from exposure to the voltage of the power distribution circuit and resulting overheating.

In an embodiment, the protection apparatus further comprises an electromagnetic actuator for opening the main switch and a powering module connected to the current-diverting circuit for powering the electromagnetic actuator and the controller, wherein the controller is configured to drive the electromagnetic actuator in order to open the main switch.

In an embodiment, the controller is configured to open at least one additional switch in response to detecting that the detection signal meets the tripping condition, the at least one additional switch being arranged between the powering module and at least one the electromagnetic actuator and the controller.

Thanks to such an additional switch, it is possible to open a connection between the powering module and at least one the electromagnetic actuator and the controller to avoid a risk that overvoltage arising in the current-diverting circuit reaches and damages the electromagnetic actuator and/or the controller. In an embodiment, a first additional switch is arranged between the powering module and the electromagnetic actuator and a second additional switch is arranged between the powering module and the controller. In an embodiment, the second additional switch is mechanically coupled to the main switch to operate simultaneously with the main switch.

In an embodiment, the current-diverting circuit comprises a plurality of parallel current paths, the parallel current paths including a neutral path for connection to a neutral line of the power distribution circuit and at least one phase path for connection to at least one phase line of the power distribution circuit.

In an embodiment, the current sensor is a leakage current sensor configured to detect a leakage current resulting in unbalanced currents in the plurality of parallel current paths.

In an embodiment, the protection apparatus further comprises a self-check button actuable by hand to create a low-impedance path between the neutral path and the phase path or one of the phase paths.

Such a self-check button may be arranged on a housing of the protection apparatus.

In an embodiment, the protection apparatus further comprises a housing equipped with circuit-side terminals for connection to the power distribution circuit and SPD-side terminals for connection to the surge protection device.

Such circuit-side terminals and/or SPD-side terminals may be implemented in different manners, for example as wire connectors for connecting to wires or as busbar connectors to connect to a busbar system. Circuit-side terminals configured as busbar connectors make it possible to connect the protection apparatus to the power distribution circuit through a busbar system. Similarly, SPD-side terminals configured as busbar connectors make it possible to connect the protection apparatus to the SPD through a busbar system.

In an embodiment, the fuse element is electrically connected between the main switch and the SPD-side terminals.

This feature is suitable for wiring the protection apparatus according to a down-line wiring arrangement.

In an embodiment, the fuse element is electrically connected between the main switch and the circuit-side terminals.

This feature is suitable for wiring the protection apparatus according to an up-line wiring arrangement.

In an embodiment, a base portion of the housing forms an enclosed space, wherein the fuse element comprises a printed circuit board or a copper frame arranged in the enclosed space and wherein the enclosed space is filled with a filler. In an embodiment, the filler is sand.

In an embodiment, a cover portion of the housing carries a handle assembly, wherein the handle assembly is connected to the main switch, wherein the handle assembly is movable in a first position to control the main switch to be in a closed state and in a second position to control the main switch to be in an open state.

In an embodiment, the invention also provides a system comprising the protection apparatus and a surge protection device, the surge protection device being connected to the current-diverting circuit, wherein the surge protection device comprises a varistor and a thermal disconnection device configured to isolate the varistor from the current-diverting circuit in response to overheating of the varistor.

### Brief description of the drawings

For a more complete understanding of example embodiments of the present invention, reference is now made to the following descriptions taken in connection with the accompanying drawings in which:
Figure 1 shows a diagrammatic representation of a protection apparatus according to a first embodiment;
Figure 2 is a graph showing different operating domains in which the protection apparatus of Fig. 1 may operate in an embodiment;
Figure 3 shows a protected power distribution system in which the protection apparatus of Fig. 1 may be employed;
Figure 4 shows a diagrammatic representation of a protection apparatus according to a second embodiment;
Figure 5 shows a protected power distribution system in which the protection apparatus of Fig. 4 may be employed;
Fig. 6 is an overall schematic diagram of a unitary implementation that may be adopted for the protection apparatus;
Fig. 7 is an exploded view of the unitary implementation of Fig. 6, showing a compact switch module and a base;
Fig. 8 is a sectional view of the unitary implementation of Fig. 6;
Fig. 9 is a partial perspective view of the unitary implementation of Fig. 6;
Fig. 10 is a partial perspective view of the unitary implementation of Fig. 6;
Fig. 11 is an internal schematic diagram of the unitary implementation of Fig. 6.

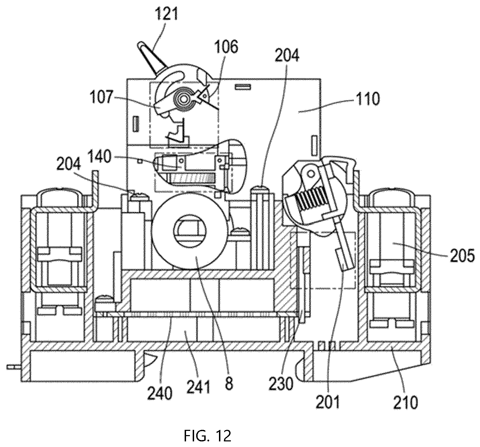

Fig. 12 is another sectional view of the unitary implementation of Fig. 6.

### Detailed description of embodiments

Example embodiments of the present application are described herein in detail and shown by way of example in the drawings. It should be understood that, although specific embodiments are discussed herein there is no intent to limit the scope of the invention to such embodiments. To the contrary, it should be understood that the embodiments discussed herein are for illustrative purposes, and that modified and alternative embodiments may be implemented without departing from the scope of the invention as defined in the claims.

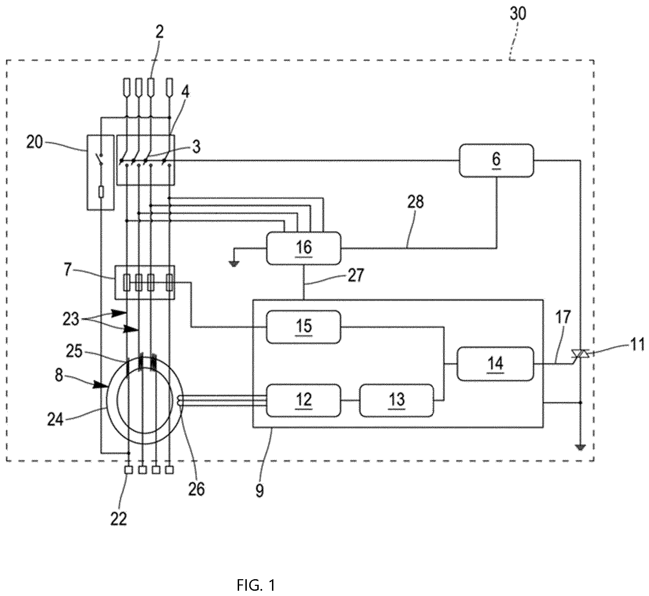

Figure 1 shows a protection apparatus 30 for protecting a surge protection device in accordance with a first embodiment.

The protection apparatus 30 comprises first terminals 2 intended to be connected to a power distribution circuit, e.g. a low voltage power distribution circuit having an operating voltage below 500V or an intermediate voltage power distribution circuit having an operating voltage below 40kV.

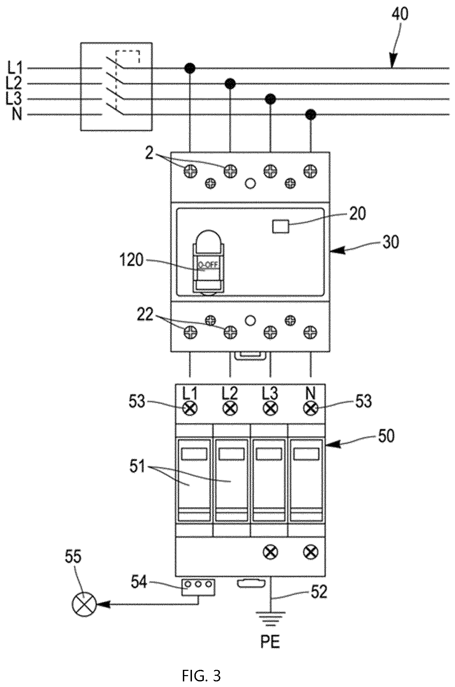

The protection apparatus 30 comprises second terminals 22 intended to be connected to a surge protection device. Between the first terminals 2 and second terminals 22, the protection apparatus 30 forms a diverting circuit having a number of parallel current paths 23. In the illustrated embodiment, four current paths 23 are provided. As shown on Fig. 3, they are intended to be connected to three phase lines L1, L2 and L3 and a neutral line N of a three-phase power distribution circuit. However a different number of current paths 23 may be provided, e.g. two current paths 23 for protecting a single-phase power distribution circuit.

Each current path 23 extends between one of the first terminals 2 and one of the second terminals 22. Each current path 23 includes a main switch 3 for selectively opening (breaking) and closing (making) the current path 23, a fuse 7 that may open (break) the current path 23 by melting in response to a rated energy, and a current sensor 8 that measures electrical current flowing in the current path 23.

The protection apparatus further comprises a power supply module 16, a detection and control module 9, a triode AC switch 11 (triac), an electromagnetic actuator 6, and an operating mechanism 4 coupled to the main switches 3. Together with the current sensor 8, those components operate as a residual current device for breaking the current paths 23 when the current sensor 8 detects a low-frequency leakage current (intermediate fault current).

For that purpose the current sensor 8 is implemented as a current transformer having a magnetic core 24, respective input windings 25 belonging to each current path 23 and output windings 26 connected to the detection and control module 9. The detection signal induced in the output windings 26 represents a leakage current, i.e. an imbalance between the currents flowing in the current paths 23. Such leakage current is not likely to occur when all current paths are connected to varistors as in a typical SPD. Therefore, the leakage current is an indication that one of the varistors may be undergoing thermal runaway and must be disconnected. However, in the absence of the low-frequency leakage current, the ability of the SPD to derive a surge current to earth, e.g. due to lightening, must remain unaffected.

For that purpose, the detection and control module 9 is configured to test whether the detection signal output by the current sensor 8 meets a tripping condition. For example, the detection and control module 9 includes a current detection and rectification circuit 12, a trip signal timer 13 and logical control module 14. The current detection and rectification circuit 12 receives, rectifies and amplifies the detection signal from the current sensor 8. Trip signal timer 13 imposes a tripping delay to ensure that the main switches 3 will not be opened due to lightening or other EMC noise. In embodiments, the tripping delay is approximately between 50ms and 100ms. However, the tripping delay in trip signal timer 13 should be precisely determined by taking into account the operating delay between the emission of trip signal 17 and actual tripping of the operating mechanism 4. The trip signal timer 13 and logical control 14 output the trip signal 17 to the triac 11 for controlling the electromagnetic actuator 6 in response to determining that the detection signal meets the tripping condition, i.e. has remained above a current threshold for a period of time longer than the tripping delay. Due to the delay, the residual current device may not be able to protect the SPD against a high-intensity fault current.

Preferably, a self-check button 20 is provided for testing whether the residual current device is operating properly. The self-check button 20 is coupled to a switch for creating low impedance derivation between a current path 23 connected to a phase line and a current path 23 connected to the neutral line, to generate a leakage current that will cause the detection and control module 9 to open the main switches 3.

When the electromagnetic actuator 6 gets a signal from the detection and control module 9 through the triac 11, it acts on the operating mechanism 4 of the main switches 3 to break the current paths 23. This happens in case there is a low-frequency leakage current as explained. Preferably, it also happens if a fuse 7 breaks.

For that purpose, the detection and control module 9 also includes a fuse status detection module 15 that monitors the status of the fuses 7 and emits a signal to the logical control module 14 in response to detecting a fuse fault. Monitoring of the status of the fuses 7 may be implemented by measuring a voltage across each fuse 7. The logical control module 14 can be implemented as a logical OR gate in that case. Hence, the logical control module 14 receives a first logical input from the trip signal timer 13 and a second logical input from the fuse status detection module 15. The logical control module 14 makes the logical analysis and outputs the trip signal 17 to the triac 11 for controlling the electromagnetic actuator 6.

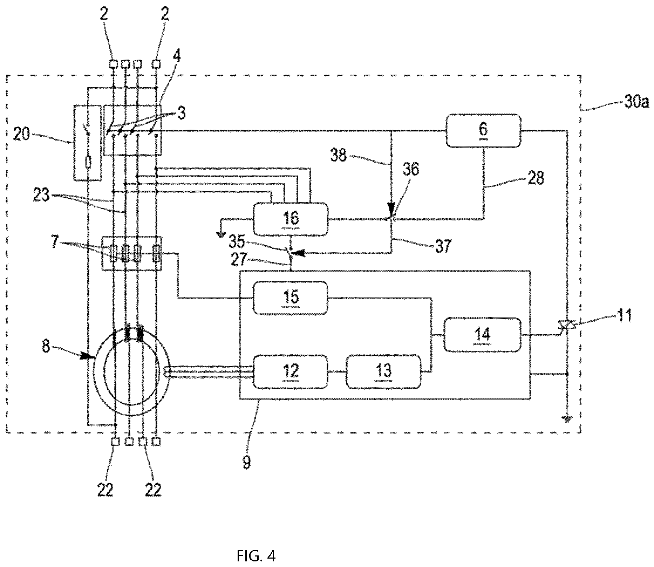

As shown, the power supply module 16 is connected to the current paths 23 before the fuses 7 in the first embodiment (Fig. 1) or behind the fuses 7 in the second embodiment (Fig. 4). The power supply module 16 supplies power from the current paths 23 to the electromagnetic actuator 6 through a connection 28 and to the control module 9 through connection 27.

The rating of the fuses 7 is selected as a function of the SPD rating so that the fuses 7 can withstand a surge current that the SPD is intended to derive to earth, whereas the fuses 7 will melt in response to the high-intensity fault current that the residual current device cannot break. For that purpose, reference may be made to standard IEC61643-12. Table 1 from that standard is appended below. This table can read as follows:
- rating of the SPD can be read in the 5^{th} column or 6^{th} column, e.g. 25kA (8/20µsec)
- minimal rating of the fuse can be read in the 1^{st} column, e.g. 80A.

For example if the SPD is intended for a surge current of 25kA (8/20µsec), the fuse 7 is rated for 80A or above, preferably 80A or 100A. If the fuse is rated too low, it may be melted by the surge current and prevent the SPD from properly fulfilling its protection function. If the fuse 7 is rated too high, it may fail to properly protect the varistors of the SPD.

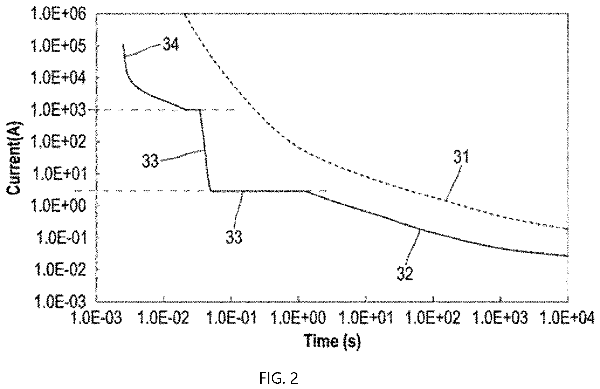

With reference to Fig.2, the operating domain of the protection apparatus 30 will now be explained in an embodiment. Figure 2 shows different graphs in a current vs. time coordinate system. Graph 31 represents an amount of energy that causes thermal runaway of the varistors employed in the SPD to be protected. Graph 32 represents an amount of energy that causes a thermal disconnection device to operate within the SPD. Graph 33 represents an amount of energy that causes the residual current device of the protection apparatus 30 to trip. Graph 34 represents an amount of energy that causes the fuses 7 of the protection apparatus 30 to melt.

As shown, the fuses 7 are suitable for withstanding the surge current and breaking the high-intensity fault current that the residual current device cannot cope with. However, if the fuse 7 is rated too high, the graph 34 will cut the graph 31 and leave a domain in which the varistors remain unprotected. Therefore, the fuse rating is preferably selected as a lowest rating that can withstand the surge current.

Fig. 3 shows an installation in which the protection apparatus 30 can be employed. The first terminals 2 are connected, e.g. by wiring or by a busbar system, to the three-phase power distribution circuit 40. The second terminals 22 are connected, e.g. by wiring or by a busbar system, to the SPD 50. The SPD 50 is a four-pole SPD of a known type. It includes four protection modules 51 connected to four input terminals 53. The protection modules 51 include varistors and may include further components, e.g. spark gaps. The SPD 50 has also an earth terminal 52 for connecting to earth. It may also include a communication interface 54 for connection to a remote signaling device 55. Further details about an embodiment of the SPD 50 may be found in the publication EP-A-0867896.

A second embodiment of the protection apparatus 30a will now be described in reference to Fig. 4. Elements that are identical or similar to those of the first embodiment are designated with the same numeral as in the first embodiment and will not be described again.

In the second embodiment the second terminals 22 are intended to be connected to the power distribution circuit, whereas the first terminals 2 are intended to be connected to the surge protection device.

The protection apparatus 30a comprises a first additional switch 35 to selectively break the connection 27 between the power supply module 16 and the detection and control module 9, and a second additional switch 36 to selectively break the connection 28 between the power supply module 16 and the electromagnetic actuator 6. The first additional switch 35 and the second additional switch 36 may be coupled to the electromagnetic actuator 6, as shown by arrows 37 and 38, so that the first additional switch 35 and the second additional switch 36 are tripped synchronously with the main switches 3.

In operation, when the electromagnetic actuator 6 gets a signal from the detection and control module 9 through the triac 11, it acts simultaneously on the operating mechanism 4 of the main switches 3, on the first additional switch 35 and on the second additional switch 36 a. As a result, the first additional switch 35 isolates the detection and control module 9 from interferences like lightening that may arise in the current paths even after tripping of the main switches 3. In much the same way, the second additional switch 36 isolates the electromagnetic actuator 6 from the power supply module 16 to protect the electromagnetic actuator 6 from damage.

For the rest, the protection apparatus 30a operates similarly to the protection apparatus 30.

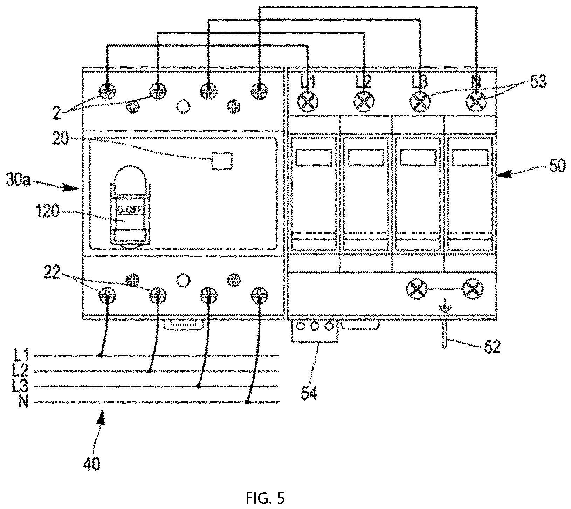

Fig. 5 shows an installation in which the protection apparatus 30a can be employed. The first terminals 2 are connected, e.g. by wiring or by a busbar system, to the SPD 50. The second terminals 22 are connected, e.g. by wiring or by a busbar system, to the three-phase power distribution circuit 40.

As visible on Figs. 3 and 5, the protection apparatus 30 or 30a preferably includes a handle assembly 120 for manually opening or closing the main switches 3.

The detection and control module 9 may be implemented through the use of dedicated hardware as well as hardware capable of executing software in association with appropriate software. When provided by a processor, the corresponding functions may be provided by a single dedicated processor, by a single shared processor, or by a plurality of individual processors, some of which may be shared. Moreover, the term "processor" or "controller" should not be construed to refer exclusively to hardware capable of executing software and may include, without limitation, central processing unit (CPU), digital signal processor (DSP) hardware, network processor, application specific integrated circuit (ASIC), field programmable gate array (FPGA), read-only memory (ROM) for storing software, random access memory (RAM), and non-volatile storage. Other hardware, conventional and/or custom, may also be included.

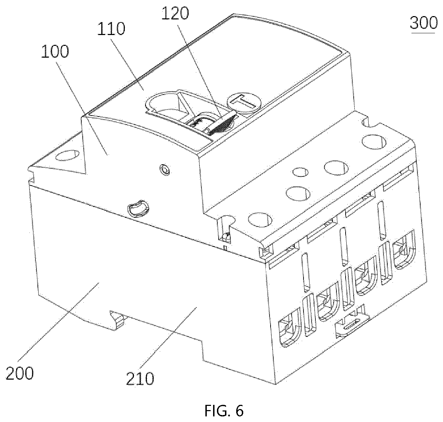

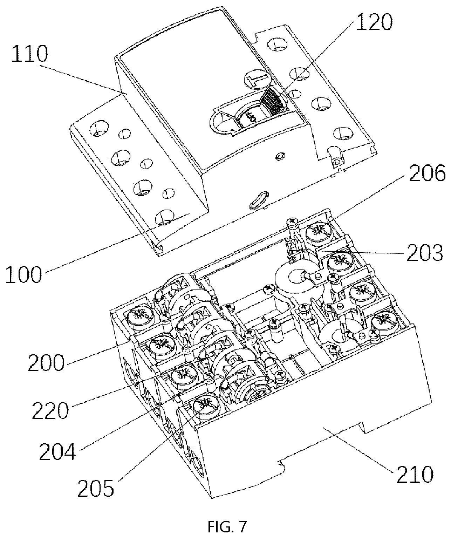

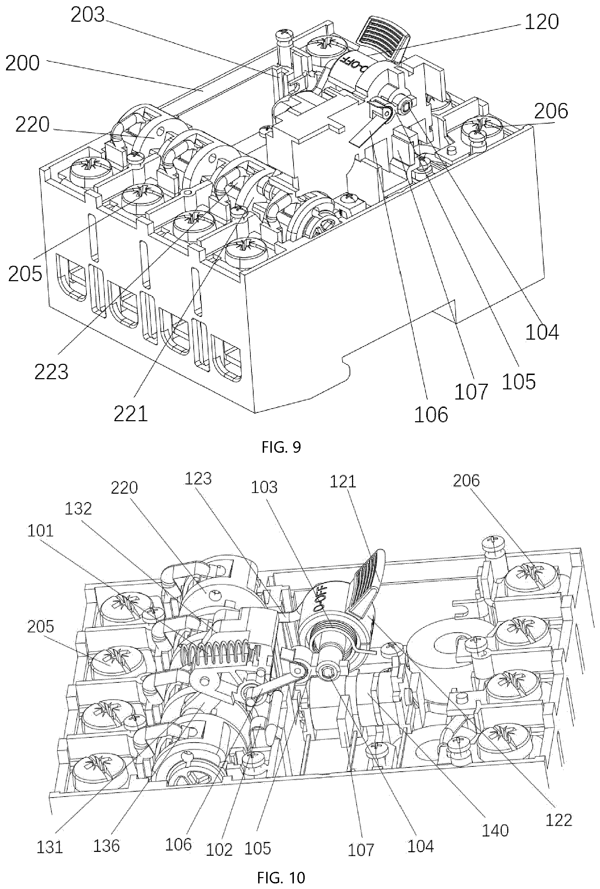

Turning to Figs. 6 to 11, a unitary implementation 300 of the protection apparatus 30 or 30a will now be described.

Referring to Figs. 6 to 11, there is shown a unitary implementation 300 comprising a compact switch module 100 and a base 200.

The compact switch module 100, comprises:
a first housing 110;
a handle assembly 120, installed in the first housing110;
a tripping mechanism 130, installed in the first housing 110, the handle assembly 120 is connected to the tripping mechanism 130, and the tripping mechanism 130 has a first output end 131, the first output end131 is movable in a first position or a second position;
an electromagnetic mechanism 140, installed in the first housing 110, the electromagnetic mechanism 140 has a movable second output end 141, and the second output end 141 is used for contacting the tripping mechanism 130.

The handle assembly 120 is used for controlling the tripping mechanism 130 to be in a locking state or a tripping state.

When the tripping mechanism 130 is in the locking state, not shown in the drawings, the first output end 131 is in the first position.

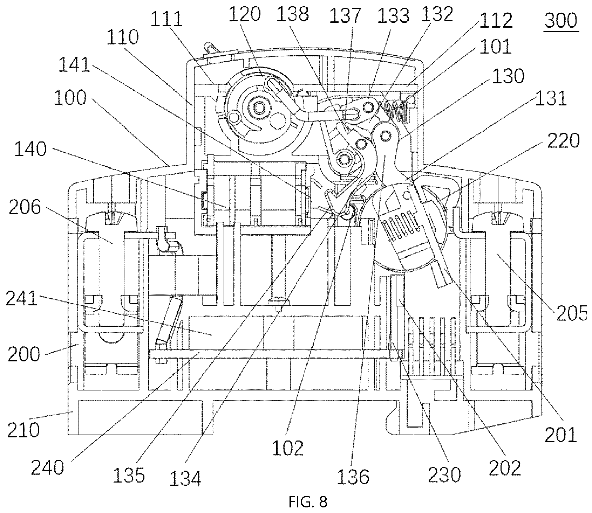

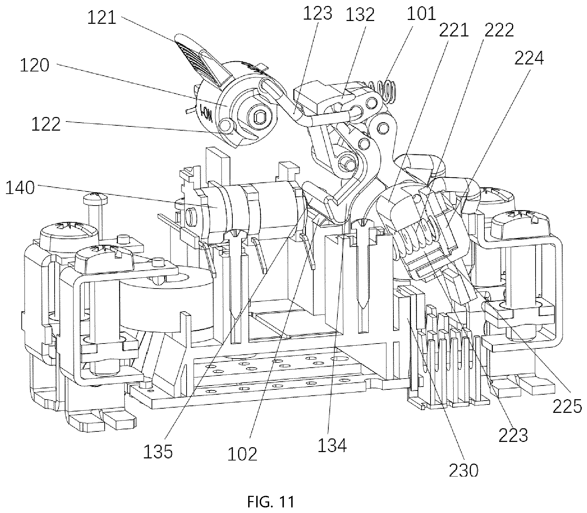

When the tripping mechanism 130 is in the tripping state, shown on Figs 8 and 11, the first output end 131 is in the second position which is different from the first position.

The electromagnetic mechanism 140 is used for driving the tripping mechanism 130 to enter the tripping state from the locking state.

Further, the first output end 131 is used for controlling the operation of a gate mechanism for circuit on/off, the gate mechanism preferably comprises a moving contact 201 and a static contact 202, and the first output end 131 is used for controlling the movement of the moving contact 201 to realize the action of closing and opening the circuit.

Preferably, the handle assembly 120 is a manual driving end, that is, the user can directly manually operate the handle assembly 120 to control the tripping mechanism 130 to be in the corresponding state, so that the first output end 131 can be switchably in different positions to trigger or end the corresponding function, and preferably the current in the corresponding circuit is turned on or off. Preferably, the first position and the second position correspond to the position where the circuit can be turned on and the position where the circuit can be turned off, respectively.

At the same time, the electromagnetic mechanism 140 is used as an electromagnetic driving end to realize automatic operation. Preferably, a control module is also arranged, the control module is used for obtaining the corresponding indication signal, and the indication signal comes from the detection of any that can be detected, such as the circuit sensor has been used, and is judged to meet the situation that the circuit is disconnected, and the electromagnetic mechanism 140 is controlled to drive the tripping mechanism 130 to carry out the corresponding state change, and the first output end 131 is returned to the initial position, so as to prevent the occurrence of low-frequency short-circuit current.

Further, as a preferred embodiment, the control module is preferably a PCBA connected to a current sensor.

Further, as a preferred embodiment, a slot structure 203 for installing a control module is arranged on the second housing 210. Further, a part of the control module may be pre-installed in the second housing 210 or the first housing 110, and then another part of the control module may be covered when the first housing 110 or the second housing 210 is installed.

Further, as a preferred embodiment, the first housing 110 comprises a first portion 111 and a second portion 112 sequentially arranged along a horizontal direction.

The handle assembly 120 is arranged at the upper part in the first portion 111, and the electromagnetic mechanism 140 is arranged at the lower part in the first portion 111.

The tripping mechanism 130 is arranged in the second portion 112, and the first output end 131 is extended downward. As employed herein, the vertical direction refers to a direction of depth of a second housing 210 that contains the gate mechanism to be controlled. In other words, the first output end 131 is extended towards the bottom of the second housing 210 that contains the gate mechanism to be controlled. The top of the second housing 210 is intended to be covered by the first housing 110.

As employed herein, the horizontal direction refers to a direction perpendicular to the vertical direction.

Further, the tripping mechanism 130 preferably has a certain extension size along the vertical direction, so that the electromagnetic mechanism 140 can contact the lower part of the tripping mechanism 130 along the horizontal direction, and through this kind of arrangement, the handle assembly 120, the electromagnetic mechanism 140 and the tripping mechanism 130 are jointly arranged in a relatively compact manner, so as to facilitate subsequent installation and disassembly; in particular, this arrangement allows the user to move the compact switch module 100 in the vertical direction and install it on the corresponding base 200.

Further, as a preferred embodiment, the first housing 110 preferably comprises: an inner housing and an outer housing, the outer housing is sleeved on the outer side of the inner housing. At least part of the tripping mechanism 130, the electromagnetic mechanism 140, and the handle assembly 120 are accommodated in the inner housing, and the other part of the handle assembly 120 is allowed to be exposed to at least the outer side of the outer housing. Further, the user can drive the entire compact switch module 100 to move by directly moving the inner housing, and make it mount to a predetermined position, and then further limit it through the outer housing.

Further, as a preferred embodiment, an opening is formed on the first housing 110, the first output end 131 passes through the opening and extends outward. Further, the first output end 131 is preferably exposed to the lower edge of the first housing 110 in order to connect to the base 200.

Further, as a preferred embodiment, the first portion 111 and the second portion 112 are preferably formed at the left and right ends of the inner housing.

Further, as a preferred embodiment, the second output end 141 is moved along a horizontal direction.

Further, as a preferred embodiment, the handle assembly 120 comprises: an operating portion 121, a rotating portion 122 and a connecting rod 123.

The rotating portion 122 is movably installed in the first housing 110, one end of the operating portion 121 is connected to the rotating portion 122, and an other end of the operating portion 121 passes through the first housing 110 and extends outwardly.

One end of the connecting rod 123 is linked with the rotating portion 122, and an other end of the connecting rod 123 is connected to the tripping mechanism 130.

Further, the operating portion 121 is a hand contact part directly operated by the user, and the user can cause the rotating portion 122 to rotate in the first housing 110 by exerting force on the operating portion 121, thereby driving the movement of the connecting rod 123.

Further, as a preferred embodiment, the rotating portion 122 may be marked with an operation gear identification, such as ON, OFF, etc., and a window, which is large enough, is formed on the first housing 110 to at least partially expose the operation gear identification on the rotating portion 122.

Further, as a preferred embodiment, the middle part of the connecting rod 123 has an obtuse angle-like bending part which is obtuse angle and is upward.

Further, as a preferred embodiment, the tripping mechanism 130 comprises:
a rotating disc 132, rotatably arranged in the first housing110;
a first connector 133, two ends of the first connector 133 are connected to the rotating disc 132 and the handle assembly 120 respectively;
a second connector 134, one end of the second connector 134 is connected to the rotating disk132 ,an other end of the second connector 134 forms a contact end 135, and the contact end 135 is used for contacting the second output end 141;
a third connector 136, one end of the third connector 136 is connected to the rotating disk 132, and an other end of the third connector 136 forms the first output end 131.

The first connector 133 matches the second connector 134 so that the tripping mechanism 130 is in the locking state or the tripping state.

Preferably, when the first connector 133 and the second connector 134 are in contact and snapped, they are in said locking state, not shown in the drawings, and when the first connector 133 and the second connector 134 move relatively easily, they are in said tripping state show on Figure 8.

Further, as a preferred embodiment, the cross-section of the rotating disc 132 along the vertical direction is preferably in a sector structure.

Further, as a preferred embodiment, the two ends of the connecting rod 123 are rotatably connected to the rotating portion 122 and the first connector 133 respectively, the first connector 133 is rotatably arranged on the rotating disc 132, the second connector 134 is rotatably arranged on the rotating disc 132, and one end of the third connector 136 is rotatably arranged on the rotating disc 132.

Further, as a preferred embodiment, when in the state as shown in Fig. 8, the first connector 133, the second connector 134 and the third connector 136 have respective hinge points with the rotating disc 132 that are respectively arranged sequentially from top to bottom.

Further, as a preferred embodiment, a protrusion 137 is formed on the first connector 133, and a depression 138 is formed on the second connector 134.

When in the locking state, the protrusion 137 extends into the inner of the depression 138.

When in the tripping state, the protrusion 137 detaches outwards from the inner of the depression 138, as shown in Fig. 8.

Further, as a preferred embodiment, the protrusion 137 protrudes outwards at the lower edge of one end of the first connector 133, in which the end of the first connector 133 is close to the connecting rod 123.

Further, as a preferred embodiment, the outer contour of the protrusion 137 is preferably in an acute angle structure.

Further, as a preferred embodiment, the depression 138 is formed in a concave at the upper edge of one end of the second connector 134, in which the end of the second connector 134 is close to the first connector 133.

Further, as a preferred embodiment, the width dimension of the lower part of the second connector 134 is greater than the width dimension of the upper part of the second connector 134, in other words, the outer contour of the second connector 134 at the lower part of the depression 138 is larger, and the outer contour of the second connector 134 at the upper part of the depression 138 is smaller, so that the protrusion 137 is easily guided outward from the upper part of the depression 138.

Further, as a preferred embodiment, the compact switch module 100 further comprises: a first elastic element 101, wherein the first elastic element 101 is arranged between the first housing 110 and the rotating disk 132.

Further, the first elastic element 101 is used for applying an elastic force to the rotating disc 132 so that it tends to approach the handle assembly 120 and to reset after tripping.

Further, as a preferred embodiment, the compact switch module 100 further comprises: a second elastic element 102, the second elastic element 102 is arranged below the tripping mechanism 130, and the second elastic element 102 is used for contacting the contact end 135 of the second connector 134. Further, the second elastic element 102 is used to provide an elastic force to the contact end 135, and the elastic force causes the depression 138 of the second connector 134 to keep close contact with the protrusion 137 of the first connector 133, in other words, the elastic force is used to make the depression 138 tend to be close to the protrusion 137, so as to ensure stability in the locking state.

Further, as a preferred embodiment, the second elastic element 102 is preferably a leaf spring with an arc-shaped bending in the upper part. Further, the upper end of the leaf spring rests against the side of the contact end 135, which is away from the electromagnetic mechanism 140.

Further, as a preferred embodiment, the second elastic element 102 is preferably directly fixed in the first housing 110 through a limiting structure, or a corresponding limiting structure is provided through the second housing 210 to locate the lower end of the second elastic element 102 and allows the upper end of the second elastic element 102 to extend upwards and be close to the contact end 135.

Further, as a preferred embodiment, a third elastic element 103 is arranged between the first housing 110 and the rotating portion 122. Further, the third elastic element 103 is used to provide the elastic force of reset of the handle assembly 120.

Further, as a preferred embodiment, the third elastic element 103 is preferably a torsion spring sleeved on a transmission shaft 104, and the rotating portion 122 is preferably rotatably mounted on the first housing 110 through the transmission shaft 104. Preferably, the transmission shaft 104 is also used for the rotational connection of the fourth connector 105.

Further, as a preferred embodiment, the compact switch module 100 further comprises: a fourth connector 105, a first moving contact 106 and a first static contact 107, the fourth connector 105 is connected to the handle assembly 120, the first moving contact 106 is arranged on the fourth connector 105, the first static contact 107 is arranged below the fourth connector 105, and the first moving contact 106 movably contacts the first static contact 107.Further, through the fourth connector 105, the first moving contact 106 and the first static contact 107, an additional switch mechanism is jointly formed, and the additional switch mechanism is used for turning on or turning off the power supply circuit of the electromagnetic mechanism 140. Preferably, this can make the electromagnetic mechanism 140 drive the tripping mechanism 130 to disconnect the circuit, and the power supply circuit of the electromagnetic mechanism 140 is also disconnected accordingly simultaneously, so that the electromagnetic mechanism 140 is protected from damage.

Referring to Figs. 6-11, the first output end 131 is used for driving at least one second moving contact 201 to contact or separate from at least one second static contact 202, and the second moving contact 201 and the second static contact 202 are used for forming a main electrical connection.

Further, a plurality of pairs of second moving contacts 201 and the second static contacts 202, which have one-to-one correspondence, can be arranged simultaneously in the unitary implementation 300, the second moving contacts 201 and the second static contacts 202 of each group correspond to the main electrical connection of a circuit, and correspondingly only need to install an above-mentioned compact switch module 100 to realize the protection of a plurality of circuits.

The first housing 110 is detachably mounted on the second housing 210. A moving contact assembly 220 is installed in the second housing 210. The first output end 131 is connected to the moving contact assembly 220, and the moving contact assembly 220 has at least one second moving contact 201, i.e. four second moving contacts 201 in the illustrated embodiment. A static contact assembly 230 is installed in the second housing 210 and the static contact assembly 230 has at least one second static contact 202, i.e. four second static contact 202 in the illustrated embodiment. The moving contact assembly 220 and the static contact assembly 230 are used for forming and breaking the main electrical connection.

Further, through the second housing 210, the moving contact assembly 220 and the static contact assembly 230, the base 200 for the compact switch module 100 is formed. Preferably, through the installation of the compact switch module 100, the first output end 131 can be connected to the moving contact assembly 220, and then the closing and opening action of the moving contact assembly 220 is controlled, so that the circuit is connected and disconnected.

In a further embodiment, the moving contact assembly 220 comprises: a rotating support 221 and at least one fourth elastic element 222. The rotating support 221 is rotatably arranged in the second housing 210, and the rotating support 221 is connected to the first output end 131.

The rotating support 221 is provided with a guide channel 223, one end of the second moving contact 201 is movably installed in the guide channel 223, and the fourth elastic element 222 is arranged between one end of the second moving contact 201 and the inner wall of the guide channel 223. Another end of the second moving contact 201 extends to the outer side of the rotating support 221 and is used for contacting the second static contact 202.

Further, the second moving contact 201 is movably arranged in the rotating support 221, and when the rotating support 221 is rotated by the force of the first output end 131, the second moving contact 201 is close to the second static contact 202 under the constraints of the guide channel 223 and the elastic action of the fourth elastic element 222, and remains stably close to it.

The guide channel 223 has at least a penetration part along the radial direction of the rotating support 221 so that the second moving contact 201 can pass therethrough, and the internal extension direction of the guide channel 223 is a diameter direction perpendicular to the penetration direction of the penetration part.

The radial section of the rotating support 221 is arranged in a circular manner, and the first output end 131 is hinged with the periphery of the radial section.

A plurality of rotating supports 221 can be arranged to carry a plurality of second moving contacts 201, or it can be achieved by a plurality of guide channels 223 being formed on a rotating support 221.

The first housing 110 and the second housing 210 are at least allowed to be detachably connected more easily.

The detachable connection of the rotating support 221 and the first output end 131 can be realized by the following method: a pin, which is parallel to the rotating shaft of the rotating support 221, passes through the peripheral of the rotating support 221 and the end of the first output end 131.

The fourth elastic element 222 is a spring that is used to provide at least an elastic force so that the second moving contact 201 tends to approach the second static contact 202, so that the second moving contact 201 and the second static contact 202 can maintain good contact.

A limiting block 224 is formed on the second moving contact 201, a limiting groove 225 is formed in the guide channel 223, and the limiting block 224 is slidably arranged in the limiting groove 225. Preferably, the slide includes, but is not limited to, translating and turning.

In a further embodiment, the unitary implementation 300 further comprises: a fuse body 240, the fuse body 240 is used to disconnect the main electrical connection. Further, the main electrical connection is disconnected by the fusing of the fuse body 240 in a predetermined condition, so that the protective effect is realized, and the disconnection occurs while the second moving contact 201 and the second static contact 202 are still in contact.

In a further embodiment, the fuse body 240 is at least electrically connected to the moving contact assembly 220 or the static contact assembly 230. Further, the electrical connection may be implemented by direct contact with the moving contact assembly 220 or the static contact assembly 230 or by indirect contact through a wire, so as to participate in the main electrical connection described above.

In the illustrated embodiment, the fuse body 240 is preferably a printed-circuit board, and one end of the fuse body 240 is electrically connected to the static contact assembly 230, and the protection can be provided in the current range of several hundred amperes to one hundred thousand amperes through the setting of the fuse body 240. The fuse body 240 can also be implemented as a copper frame.

The lower part of the second housing 210 forms an enclosed space 241, the fuse body 240 is arranged in the enclosed space 241, and the enclosed space 241 is filled with filler. The filler is preferably sand.

In a further embodiment, the first housing 110 is fixed to the second housing 210 through a plurality of screws 204.

In a further embodiment, the two sides of the first housing 110 have extension parts that cover the upper part of the second housing 210 by extending outward in a horizontal direction.

In a further embodiment, each of the extension parts is provided with a screw hole for the installation of the screw 204.

The unitary implementation 300 further comprises: at least one first terminal 205 and at least one second terminal 206 for connecting to an external circuit, the first terminal 205 and the second terminal 206 are all arranged in the second housing 210, the first terminal 205 is electrically connected with the second moving contact 201, and the second terminal 206 is electrically connected to the other end of the fuse wire 240.

The electrical connection between the terminal and other structures is preferably through wires, busbars, etc.

In a further embodiment, the outer wall of the second housing 210 is provided with an interface for connecting the external line to the corresponding terminal.

Referring to Fig. 1, the main switch 3 may be implemented by the moving contact 201 and static contact 202 and the electromagnetic actuator 6 by the electromagnetic mechanism 140. Referring to Fig. 4, the second additional switch 36 may be implemented by the first moving contact 106 and the first static contact 107.

In an embodiment, the first additional switch 35 is controlled by the second additional switch 36, so that when the second additional switch 36 is open, the first additional switch 35 will also open. The first additional switch 35 may be implemented as an electronic optocoupler switch.

It will be obvious to a person skilled in the art that, as the technology advances, the inventive concept can be implemented in various ways. The invention and its embodiments are not limited to the examples described above but may vary within the scope of the claims.

**Table 1**

| **Withstand capabilities of gG fuse-links towards operating and additional duty tests** | | | | | |
|---|---|---|---|---|---|
| **Rated current of fuse link (A)** | **Minimum prearcing I²t (Table 113, IEC 60269-2))** | **Evaluated minimum Adiabatic I²t (A²s)** | **Safety coefficient (on the value of current)** | **Maximum Iₙ (kA) (8/20 µsec )** | **Maximum I_{Imp} (kA) (10/350 psec)** |
| 8 | 40 | 24 | 0,85 | 1,2 | 0,3 |
| 10 | 68 | 41 | | 1,5 | 0,3 |
| 12 | 130 | 78 | | 2,1 | 0,5 |
| 16 | 291 | 175 | | 3,1 | 0,7 |
| 20 | 640 | 384 | | 4,6 | 1.0 |
| 25 | 1 210 | 726 | | 6,4 | 1,4 |
| 32 | 2 500 | 1 750 | | 9,9 | 2,2 |
| 40 | 4 000 | 2 800 | | 12,5 | 2,8 |
| 50 | 5 750 | 4 025 | | 15 | 3,4 |
| 63 | 9 000 | 6 300 | | 19 | 4,2 |
| 80 | 13 700 | 10 960 | | 25 | 5,6 |
| 100 | 21 200 | 19 080 | | 33 | 7,3 |
| 125 | 36 000 | 32 400 | | 42 | 9,6 |
| 160 | 64 000 | 57 600 | | 57 | 13 |
| 200 | 104 000 | 93 600 | | 72 | 16 |
| 224 | 139 000 | 125 100 | | 83 | 19 |
| 250 | 185 000 | 166 500 | | 96 | 22 |
| 315 | 302 000 | 271 800 | | 123 | 28 |
| 400 | 557 000 | 445 600 | | 157 | 35 |
| 500 | 900 000 | 720 000 | | 200 | 45 |
| 630 | 1 600 000 | 1 280 000 | | 267 | 60 |

## Claims

1. A protection apparatus (30, 30a) for protecting a surge protection device (50), the protection apparatus comprising:
a current-diverting circuit connectable between a surge protection device and a power distribution circuit, the current-diverting circuit comprising a main switch (3), the current-diverting circuit and the surge protection device being configured to divert a surge current from the power distribution circuit (40),
a current sensor (8) configured to generate a detection signal in response to detecting a current in the current-diverting circuit,
and a controller (9) configured to test a tripping condition and to open the main switch (3) in response to detecting that the detection signal meets the tripping condition, wherein the tripping condition is configured to avoid opening the main switch in response to the surge current,
wherein the current-diverting circuit further comprises a fuse element (7) connected in series with the main switch, wherein the fuse element is rated to withstand the surge current and to melt into an open state within an urgent disconnection delay in response to a high intensity current, wherein the urgent disconnection delay is shorter than a time required by the controller to test the tripping condition.

2. The protection apparatus according to claim 1, wherein the tripping condition is a function of a time threshold, wherein testing the tripping condition comprises testing that the detection current remains above a positive detection threshold for a duration longer than the time threshold, the time threshold being longer than a typical duration of the surge current.

3. The protection apparatus according to claim 1 or 2, wherein the controller (9) is further configured to detect the open state of the fuse element and to open the main switch in response to detecting the open state of the fuse element.

4. The protection apparatus according to any one of the claims 1 to 3, further comprising an electromagnetic actuator (6) for opening the main switch and a powering module (16) connected to the current-diverting circuit for powering the electromagnetic actuator and the controller, wherein the controller is configured to drive the electromagnetic actuator (6) in order to open the main switch (3).

5. The protection apparatus according to claim 4, wherein the controller is configured to open at least one additional switch (35, 36) in response to detecting that the detection signal meets the tripping condition, the at least one additional switch (35, 36) being arranged between the powering module (16) and at least one the electromagnetic actuator (6) and the controller (9).

6. The protection apparatus according to any one of the claims 1 to 5, wherein the current-diverting circuit comprises a plurality of parallel current paths (23), the parallel current paths including a neutral path for connection to a neutral line of the power distribution circuit and at least one phase path for connection to at least one phase line of the power distribution circuit, wherein the current (8) sensor is a leakage current sensor configured to detect a leakage current resulting in unbalanced currents in the plurality of parallel current paths (23).

7. The protection apparatus according to claim 6, further comprising a self-check button (20) actuable by hand to create a low-impedance path between the neutral path and the phase path.

8. The protection apparatus according to any one of the claims 1 to 7, further comprising a housing (110, 210) equipped with circuit-side terminals (2, 22) for connection to the power distribution circuit and SPD-side terminals (22, 2) for connection to the surge protection device.

9. The protection apparatus (30) according to claim 8, wherein the fuse element (7) is electrically connected between the main switch and the SPD-side terminals (22).

10. The protection apparatus (30a) according to claim 8, wherein the fuse element (7) is electrically connected between the main switch (3) and the circuit-side terminals (22).

11. The protection apparatus according to any one of the claims 8 to 10, wherein a base portion (210) of the housing forms an enclosed space (241), wherein the fuse element (7) comprises a printed circuit board or a copper frame arranged in the enclosed space (241) and wherein the enclosed space is filled with a filler.

12. The protection apparatus according to any one of the claims 8 to 11, wherein a cover portion (110) of the housing carries a handle assembly (120), wherein the handle assembly (120) is connected to the main switch (3), wherein the handle assembly is movable in a first position to control the main switch to be in a closed state and in a second position to control the main switch to be in an open state.

13. A system comprising the protection apparatus (30, 30a) according to any one of the claims 1 to 12 and a surge protection device (50), the surge protection device being connected to the current-diverting circuit, wherein the surge protection device comprises a varistor and a thermal disconnection device configured to isolate the varistor from the current-diverting circuit in response to overheating of the varistor.
